# EUROPEAN PATENT APPLICATION

(11) **EP 2 629 265 A1**
(43) Date of publication of application: **21.08.2013**
(21) Application number: 12195785.6
(22) Date of filing: 06.12.2012
(51) Int. Cl.: G06T 13/20, G06T 13/40

(54) **Method and system for driving simulated virtual environments with real data**

(30) Priority: 16.02.2012 US 201261599909 P
(71) Applicant: Crytek GmbH, 60322 Frankfurt am Main (DE)
(72) Inventor: Yerli, Cevat, 60314 Frankfurt/Main (DE)
(74) Representative: Schmidt, Steffen

(57) **Abstract**

A method and a processing pipeline for driving a simulated virtual environment with real data are described. The method is described with regard to visualization and interaction with real and virtual data in simulated virtual environments. The method for driving a simulated virtual environment with real data comprises providing a simulated virtual environment including a plurality of virtual objects in a virtual scene, providing captured data related to one or more real objects of a real scene to the virtual environment, assigning the captured data to corresponding virtual objects, updating the plurality of virtual objects in the virtual scene, and rendering the virtual scene of the simulated virtual environment, wherein the virtual scene is rendered in real-time with regard to providing the captured data. A system for driving a simulated virtual environment with real data is also described.

## Description

### TECHNICAL FIELD

The present invention relates to simulated virtual environments and, in particular, to a method and a processing pipeline for driving a simulated virtual environment with real data. Moreover, the present invention may relate to visualizing and interacting with real and virtual data in simulated virtual environments.

### BACKGROUND

Computer graphics generally refers to techniques that enable computer-generated visual representations of graphical objects or components. The objects and components and their characteristics may be defined in a two or three dimensional virtual environment. Moreover, physical behaviour, such as dynamics and kinematics, of the objects and components within the virtual environment may be simulated to resemble a real-world environment. Typically, one or more views of the virtual environment and the objects therein are rendered and displayed on a display of the graphics computer. The simulated virtual environments may be influenced by a direct user input. For example, a user may specify or modify a position of a graphical object within the virtual environment.

The use of further input to simulated virtual environments based on real data, such as motion tracking data, which influences the objects and components of simulated virtual environments is an emerging technique. However, present systems used to simulate and display such components often focus on visualization only and typically do not appropriately integrate the real data into the simulated virtual environments. In particular, the processing of the real data and the simulation of the virtual environment are often delayed and therefore do not allow for an immediate feedback. Furthermore, current systems often include a conglomeration of software components and therefore do not provide for an integrated processing of the real data and corresponding graphical objects and components of the simulated virtual environment.

Thus, there is a need in the art for a method and a system that enable an integrated simulation of virtual environments based on real data that drives respective graphical objects and components of the environment, which allows for a seamless simulation and immediate representation of the virtual environment. In view of the above, one object is to improve the integration of real data into simulated virtual environments.

### SUMMARY

The problem is solved by a method, a processing pipeline, and a system for driving simulated virtual environments with real data as defined in the independent claims. Preferred embodiments are defined in the corresponding dependent claims.

The method for driving simulated virtual environments with real data according to the present disclosure provides a simulated virtual environment including a plurality of virtual objects in a virtual scene. Captured data related to one or more real objects of a real scene is provided to the virtual environment and assigned to corresponding virtual objects. The virtual objects in the virtual scene are updated and the virtual scene of the simulated virtual environment is rendered, wherein the virtual scene is rendered in real-time with regard to providing of the captured data.

The virtual environment and the virtual objects therein may be simulated, for example, by a 3D engine or another suitable computer-based simulation engine or system capable of managing virtual objects or components of a synthetic environment and simulating the behaviour of the environment and the virtual objects within according to, for example, physical properties. The shape and appearance of the virtual objects may be defined as meshes and corresponding surface properties may be defined, for example, as textures, colour data and other visual properties. In addition, for each object material characteristics and other features may be defines.

The simulation engine may analyze, for each time step, the current transformation, such as the position and orientation, of each virtual object and may simulate the next state of each virtual object. For example, the simulation engine may determine a motion of a virtual object with regard to a simulated gravitation in the virtual environment. Also, collisions between virtual objects may be handled and, for example, the shape of the colliding virtual objects may be adjusted according to the physical properties of the virtual objects. The simulation is performed in real-time, such that each simulated time step corresponds to the elapsed real time and the simulation results are available instantaneously or with only a short delay of less than 500 ms, preferably of less than 100 ms and most preferably of less that 50 ms. The simulation leads to an updated virtual environment.

The simulation engine may analyze the updated virtual objects in the virtual scene of the virtual environment and render a visual representation of the respective virtual objects based on the current shape and appearance of the virtual objects, environmental factors defined by the virtual environment, and settings of the virtual scene defining, for example, a view on the virtual environment. The engine is preferably configured to perform the rendering in real-time. Hence, the visual representation is available instantaneously or with a short delay only, which may be equal to or less than the short delay of the simulation. Preferably, the simulation and rendering of the virtual environment may be de-coupled, each being performed independently and concurrently, such that the rendering step always uses the recent state of the virtual environment and the current settings of the virtual scene to generate a visual representation at an interactive frame rate and, independently thereof, the simulation step updates the state of at least some of the virtual objects preferably at another rate.

The simulation of the virtual environment is directly influenced by captured data related to the real objects of the real scene. The captured data may comprise information, which may be directly mapped to certain properties of at least one of the virtual objects. For example, the motion of a real object in the real scene may be captured and the captured motion data may be used to affect the current position and orientation of a corresponding virtual object in the virtual scene. However, the captured data may as well comprise a set of structured or unstructured data related to a plurality of the real objects, such as a depth map of the real scene or a video recording of the real scene. Such data may be, for example, analyzed and matched to corresponding virtual objects.

The virtual scene and the virtual objects therein may represent a copy of the real scene and the real objects therein, leading to a one-to-one mapping between virtual and real objects. However, either the virtual or the real scene may as well comprise additional virtual and real objects, respectively, such that objects need not to have a matching object in virtual or real scene. Furthermore, a real object may, as well, correspond to a plurality of virtual objects and vice versa, leading to a one-to-many or many-to-one mapping, respectively. For example, a real object may correspond to an actor or another articulated structure and the related captured data may be mapped to a plurality of virtual objects representing the articulated structure, such as a virtual skeleton representing the actor.

Accordingly, the captured data of the real object(s) may be analyzed and mapped on the corresponding virtual object(s), such that the properties of the affected virtual object(s) are updated based on at least a portion of the captured data. The simulation engine may analyze the updates and simulate the state of the virtual environment based on the external real data and internal conditions, such as a simulated motion of virtual objects that does not correspond or is not affected by any external data. Also with regard to the external real data input, the simulation engine is configured to simulate and render the virtual scene of the updated virtual environment in real-time. This may, for example, be accomplished by prioritizing the simulation of virtual objects affected by the external physical data input and delaying the simulation of unaffected virtual objects. Also, an environment, such as a bounding box or sphere or an area defined by a suitable distance metric, of each virtual object updated by captured data may be analyzed for neighbour virtual objects, which may, as well, be regarded in the current simulation step. However, in order to guarantee simulation and rendering of the updated virtual environment in real-time, the neighbour virtual objects may be simulated with a reduced priority or the simulation may even be postponed to a subsequent simulation step, enabling a rendering of an intermediate state of the virtual environment in real-time.

The method allows for an integrated simulation of virtual environments based on real data that drives respective graphical objects and components of the environment. The method further allows for a seamless simulation and immediate rendering of the virtual scene of the virtual environment enabling an immediate feedback on the current state of the virtual scene.

A first aspect of the present disclosure comprises capturing at least some of the data related to the one or more real objects of the real scene in real-time. For example, the captured data may correspond to motion tracking data of real objects or a live video recording of the real scene which is mapped on corresponding virtual objects of the virtual scene.

In a preferred embodiment, providing the captured data comprises streaming the captured data live into the virtual environment in real-time. The data may be, for example, captured from actors, cameras, and hardware devices and may be directly provided to the virtual environment or a respective simulation engine, such as the 3D engine, which drives the corresponding virtual objects leading to synchronized computer graphics-based components in real-time.

According to a particularly preferred embodiment, capturing the data comprises recording the real scene using a real camera. The real camera may be a conventional video camera providing a stream of video data that is directly provided to the simulation engine in real-time. The real camera may as well be a stereo camera providing a stream of stereoscopic video data and additional data, such as a depth map of the real scene. Obviously, the real scene may as well be captured by two or more cameras and the respective streams may be simultaneously provided to the simulation engine.

Preferably, the method further comprises synchronizing a virtual camera inside the virtual scene with the real camera, wherein the virtual scene is rendered using the virtual camera. In particular, the virtual camera may define a view on the virtual scene of the virtual environment, which will be subsequently rendered. The real camera may be mapped to the virtual camera similar to mapping of real objects to virtual objects. In particular, a position and orientation and further camera settings, such as aperture, may be derived from the real camera and used to update corresponding settings of the virtual camera. For example, if the real camera is being moved with regard to the real scene, the virtual camera may directly follow the motion of the real camera and the resulting modified view on the virtual scene may be provided in real-time to generate an instantaneous feedback. The real data related to the real camera may be directly derived from the camera settings. Also, the real data of the real camera may be determined by a further capturing device, such as a motion tracker capturing the motion of the real objects as well as of the real camera. Furthermore, if two or more cameras or at least one stereo camera are being used to capture the real scene, each real camera or each view of the stereo camera may be associated with a corresponding virtual camera in the virtual scene. The simulation engine may be configured to select one of the virtual cameras or a pair of the virtual cameras related to the stereo camera as an active camera used for rendering of the virtual scene. Alternatively, only one virtual camera or a virtual stereo camera may be defined in the virtual environment and the real cameras may be selectively mapped to the one virtual camera.

In yet another embodiment, capturing the data comprises capturing motion of a real object. Various techniques for motion tracking may be used, such as an electromagnetic, acoustical or optical tracking based on markers or a marker-less tracking approach.

According to a particularly preferred embodiment, providing the captured data further comprises re-targeting the captured motion data of the real object to a corresponding virtual object. The tracked real object may be previously registered and mapped to the virtual object. For example, an actor may be directly mapped to one or more virtual objects representing the body structure of the real actor. In addition, the respective virtual objects may be connected with each other to form an articulated structure, such as a skeleton, in order to facilitate motion simulation of the virtual body related to the actor. The actor may be configured with a plurality of markers and the motion tracking system may provide the position and, possibly, the orientation of each marker to the simulation engine. The transformation of each marker, such as a marker attached to an arm of the actor, may be mapped to the respective virtual object which may, for example, represent a virtual arm of the actor, thereby influencing the transformation of the virtual object. After updating all virtual objects related to the actor the simulation engine may compute the motion of the articulated structure, for example, by employing inverse kinematics or another suitable simulation approach.

According to another aspect, capturing the data includes capturing the data from at least one of an actor, other real objects of the real scene, a real camera, and other devices capturing data of the real scene. Other real objects may comprise animals, vehicles, and other tools used in the real scene. Other capturing devices may comprise tracking devices, infrared cameras, systems for recording depth information and others.

In yet another preferred embodiment, the method further comprises generating data for at least some of the virtual objects based on the captured data, including at least one of motion data, meshes, and textures for the respective virtual objects. In particular, captured data of a plurality of real objects, for example, a video stream or a depth map stream representing several filmed objects, such as static props, vegetation, living persons or animals, or anything else, as much as the landscape or buildings, may be used to generate 3D meshes and textures representing the real objects, which may be used to modify the virtual objects.

Also, the generated representations may be re-fined over time with new captured data available for the respective real object. Hence, previously generated meshes and textures of a virtual object may be updated based on the current recording. The longer the real scene or an object within the real scene are recorded, the better the quality and precision of the corresponding generated representation will be, which may be used to modify or even replace the real object. For example, to generate detailed data for a virtual object corresponding to an actor, the real camera may execute a full scan around the actor, such as a 360° walk around the actor. The resulting extracted and generated data of the 3D representation of the real scene are continuously updated and improved to closely resemble the real recording. For example, the level of detail of extracted meshes may be improved by interpolating subsequently extracted meshes. Furthermore, the texture quality may increase continuously as long as the object stays in view of the real camera.

The captured data, such as a continuous stream of stereo images or a depth map of the real scene, may further be used to extract the motion data of real objects related to respective virtual objects. The motion data may be preferably mapped to a skeleton, representing the kinematics of the underlying virtual object. Furthermore, if motion tracking data are available for a real articulated object in the real scene, the motion tracking data may be mapped to the motion of the skeleton of the related virtual object. Pre-defined skeletons may be used for kinematics of well known articulated objects, such as human beings or animals. In addition, skeletal data may be derived automatically from the motion of the meshes and respective degrees of freedom of the motion. The motion of a virtual object may be calculated as an animation track. The approach allows for animation of simple static objects as well as kinematics and animation of complex objects, such as human characters, including animations of the full body and facial animations. The combination of meshes, textures and all motion data results in a lifelike one-to-one representation of any moving or static object of the real scene. Further combinations of the extracted and generated data may be used to improve the 3D representation of the real scene.

In another embodiment, the method further comprises creating a three-dimensional representation of the real scene based on the captured data and compositing at least the three-dimensional representation of the real scene with the rendering of the virtual scene. The captured data of the real scene may, for example, comprise a live recording of the real scene and further data enabling depth estimation for the recorded objects. Thus, the three-dimensional representation may comprise depth information in order to enable correct overlapping of the virtual and real objects in the composited images. An approach to compositing of live recordings with computer graphics-generated media streams applicable in the method is described in the pending US application of the applicant entitled "Real-Time Compositing of Live Recording-Based and Computer Graphics-Based Media Streams," filed on February 16, 2012, as U.S. Patent Application No. 61/599,905, the entire content of which is incorporated herein by reference.

According to a preferred embodiment, the method further comprises retrieving at least some of the captured data from a data store.

In yet another preferred embodiment, the method further comprises recording a simulation of the virtual environment based on the captured data and interactively replaying the simulation. For example, particular simulation results may be recorded and played back at any time, without the need for the original inputs. Using this approach, a user, such as a director may frame a virtual scene, for example with virtual camera hardware, based on previously recorded actor motions driving computer-generated characters, long after the real actors have left the premises.

According to a particularly preferred embodiment, the method further comprises interacting with the virtual environment based on the rendering of the virtual scene.

Preferably, interacting with the virtual environment includes selecting at least some of the virtual objects and editing the selected virtual objects. In particular, the real data captured from, for example, actors, cameras, and hardware devices, is used to drive synchronized computer graphics-based objects in real-time. The virtual objects exist in the environment simulation and can be interacted with or edited by any user viewing the environment, such as the rendering of the virtual scene.

In a particularly preferred embodiment, interacting with the virtual environment further includes controlling a virtual camera using an input device. The input device may be at least one of a mechanical control, a touchpad, and a portable or mobile device. The input device may, for example, be coupled to a real camera in order to directly control the virtual camera with data derived from the real camera. However, the input device may as well be completely independent of a real camera. For example, the input device may be coupled to a control unit, such as a desktop, and used to update a transformation of the related virtual camera. The input device may as well be used directly at the real scene during recording, however, independent of the real camera. For example, a director may use a portable device to adjust the transformation and further parameters of the virtual camera during recording of the real scene. Thus, the input device may be provided as a mobile device, such as a laptop, tablet PC, palmtop, a smartphone, or any other suitable remote device.

According to a particularly preferred embodiment, interacting with the virtual environment includes interacting with the virtual environment by a plurality of users collaborating in real-time. In particular, the method according to an embodiment is focused on creating a realistic simulated virtual environment where multiple people can collaborate in real-time. The data input of motion capture actors, cameras, virtual cameras, props, objects, set pieces, etc in conjunction with the simulation of the virtual environment create a virtual world synchronized with those data streams.

According to another aspect, the method further comprises providing the rendering directly at the real scene. Naturally, the processing of the captured data, the simulation of the virtual environment and rendering of the corresponding output may cause a certain delay. Yet, the use of real-time simulation and rendering enables a very fast computation, such that the resulting media stream may be directly provided at the real scene, for example, directly at the real camera in real-time, i.e., within a short period of time, which is preferably unnoticeable to a human operator of the real camera or at least with a certain delay, which is not perceived as disturbing for the respective operator, such as of less than 1.0 second, preferably of less than 0.5 seconds, and most preferably of less than or equal to 100 ms. Providing the final rendering directly at the real scene, for example using any suitable output hardware, such as a monitor or even a real camera itself, enables an immediate detection of any problems with regard to the final rendering of the virtual environment. Thus, the recording of the real scene can be adjusted in order to handle any problems leading to a significant reduction of production costs by speeding up the production cycles.

In yet another preferred embodiment, the method further comprises simulating the virtual environment by a real-time 3D engine.

Furthermore, a computer-readable medium according to the present invention has instructions stored thereon, wherein said instructions, when installed and executed on a computing device, cause said computing device to automatically perform a method according to an embodiment of the present disclosure. In particular, the computer-readable medium may be accessed by a processing unit of a system for driving a simulated virtual environment with real data and the instructions may be transferred to the processing unit, which may execute at least some of the instructions. The processing unit may, for example, execute at least some of the instructions to configure a processing pipeline to perform the respective method. In particular, the instructions may configure the processing unit and/or the processing pipeline to provide a simulated virtual environment including a plurality of virtual objects in a virtual scene and to receive captured data related to one or more real objects of a real scene, which may be provided to the virtual environment. Furthermore, the instructions may configure the processing unit and/or the processing pipeline to assign the captured data to corresponding virtual objects, update the plurality of virtual objects in the virtual scene, and render the virtual scene of the simulated virtual environment, wherein the virtual scene is rendered in real-time with regard to providing the captured data.

A processing pipeline for driving a simulated virtual environment with real data according to the present disclosure, said processing pipeline being implemented and executed on at least one computing device, comprises an input module configured to receive captured data related to one or more real objects of a real scene; an output module configured to render a virtual scene of a simulated virtual environment; and one or more interconnected processing modules, at least one of the processing modules being connected to the input module and at least one of the processing modules being connected to the output module. Said processing modules are configured to provide the simulated virtual environment including a plurality of virtual objects in a virtual scene; assign the captured data to corresponding virtual objects; and update the plurality of virtual objects in the virtual scene, wherein said processing pipeline is configured to render the virtual scene in real-time with regard to providing the captured data.

The processing modules performing certain processing steps may be executed sequentially. However, one or more processing modules may as well be executed concurrently. Furthermore, particular processing modules may be implemented on dedicated computing devices and hardware. For example, a processing module may perform simulation of the virtual environment and another processing module may perform rendering of the simulated virtual environment. Both modules may be distributed to different computing devices or to different parts of a computing device. For example, while the simulation may be performed by one or more cores of a central processing unit, the entire rendering may be performed on dedicated graphics hardware. Yet, it is to be understood that at least some of the processing modules of the pipeline may as well be executed on the same computing device or processing parts of a computing device. For example, at least some of the processing cores of the central processing unit may be used to simulate and render the virtual environment. Also, the graphics hardware alone may be used to simulate and render the virtual environment, for example using a dedicated graphics processing unit.

For example, the pipeline may comprise at least two processing modules. A first processing module may provide and simulate the virtual environment. A second processing module may be coupled to the input module and the first processing module and may be configured to assign the captured data to corresponding virtual objects by passing the respective information and data to the first processing module. The first processing module may further be configured to update the plurality of virtual objects in the virtual scene and to perform the simulation. The first processing module may be couple to the output module providing any suitable information on the state of the simulated virtual environment, such that the output module may perform the real-time rendering of the virtual environment. Yet, it is to be understood that the pipeline may also comprise three or more, or four or more interconnected processing modules, each dedicated to a particular task.

The processing modules may preferably exchange the data via a shared memory architecture, enabling concurrent access to the data. Yet, the processing modules may also encapsulate private data and send respective information to connected modules via messages, shared buffers, and other data exchange techniques.

In a further embodiment, the input module is further configured to capture at least some of the data related to the one or more real objects of the real scene in real-time.

According to a preferred embodiment, the input module is further configured to stream the captured data live to the processing module providing the virtual environment in real-time.

According to a particularly preferred embodiment, the pipeline further comprises a processing module configured to synchronize a virtual camera inside the virtual scene with the real camera, wherein the virtual scene is rendered using the virtual camera.

In yet another embodiment, the input module is further configured to re-target the captured motion data of the real object to a corresponding virtual object.

According to a particularly preferred embodiment, the pipeline further comprises a processing module configured to record a simulation of the virtual environment based on the captured data and interactively re-play the simulation.

According to another aspect, the pipeline further comprises another input module interconnected with at least one of the processing modules, being configured to enable interaction with the virtual environment based on the rendering of the virtual scene.

In yet another preferred embodiment, said another input module is configured to further enable controlling a virtual camera using an input device.

In a further embodiment, said another input module is further configured to enable interaction with the virtual environment by a plurality of users collaborating in real-time.

Furthermore, a system for driving a simulated virtual environment with real data according to the present disclosure comprises a processing unit providing a simulated virtual environment including a plurality of virtual objects in a virtual scene, said processing unit including a pipeline according to an embodiment of the present disclosure. Furthermore the system comprises an input interface receiving captured data related to one or more real objects of a real scene, configured to provide the captured data to the input module of the pipeline; and an output interface providing the rendering of the virtual scene of the simulated virtual environment received from the output module of the pipeline, wherein the virtual scene is rendered in real-time with regard to providing the captured data.

According to a preferred embodiment, the system further comprises a capturing device to capture at least some of the data related to the one or more real objects of the real scene in real-time.

In a preferred embodiment, the capturing device includes a real camera configured to record the real scene.

According to a particularly preferred embodiment, the capturing device further includes a motion tracking device configured to capture motion of at least one real object.

According to another embodiment, the system further comprises a data store coupled to the processing unit to store and retrieve at least some of the captured data.

In yet another embodiment, the system further comprises an interaction unit coupled to the processing unit, configured to enable interaction with the virtual environment based on the rendering of the virtual scene provided by the output interface.

According to a particularly preferred embodiment, the interaction unit further comprises an input device to control a virtual camera in the virtual environment.

According to another aspect, the system further comprises one or more output devices coupled to the output interface. For example, the output devices may be provided at the real scene in order to enable a direct feedback on the recording of the real data and the resulting rendering of the virtual environment.

In yet another preferred embodiment, the processing unit includes a real-time 3D engine configured to simulate the virtual environment.

### BRIEF DESCRIPTION OF THE DRAWINGS

The specific features, aspects and advantages of the present disclosure will be better understood with regard to the following description and accompanying drawings where:

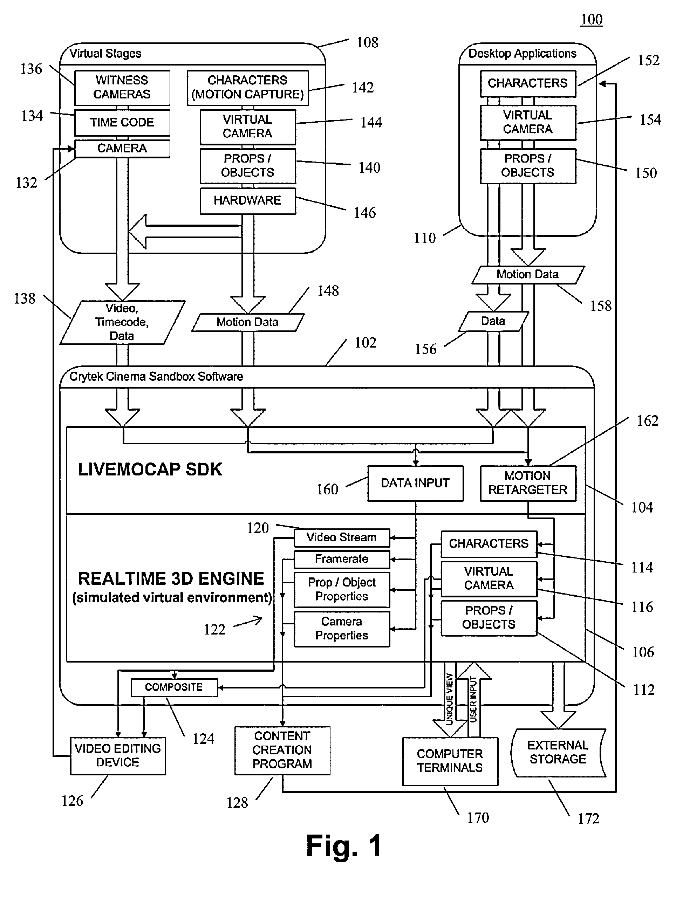

FIGURE 1 shows a system for visualizing and interacting with data in a simulated virtual environment according to an aspect of the present disclosure.

### DETAILED DESCRIPTION

In the following description of preferred embodiments reference is made to the drawings which show by way of illustration a specific embodiment. It is to be understood that the embodiments may include changes in design and structure without departing from the scope of the present invention as defined in the claims.

FIGURE 1 shows a system for visualizing and interacting with data in a simulated virtual environment according to a preferred embodiment. The system 100 comprises a processing unit 102 hosting a motion capture component 104 and a real-time 3D engine 106. The processing unit 102 receives input from a virtual stage 108 that represents a real scene and provides respective captured data to the processing unit 102. Furthermore, the processing unit 102 receives input from an application 110. The processing unit 102 generates output and provides respective data to the virtual stage 108 and the application 110.

Engine 106 provides a simulated virtual environment including a plurality of virtual objects 112 and characters 114. The virtual environment is simulated by the engine 106. Furthermore, the engine 106 renders the virtual environment based on a virtual camera 116. For example, the virtual camera 116 may define a viewpoint and a perspective of a view on the virtual objects 112 and characters 114 within the virtual environment.

The engine 106 may also store a respective video stream 120 of the captured real scene and further data 122 on the captured real scene, such as, frame rate information, properties of props or objects, and camera properties. The video stream 120 may be used together with the rendering of the virtual environment to generate a composite media stream 124, including the real recording and the virtual rendering. The real video stream 120 and the compositing results are supplied to a video editing module 126, which provides respective media streams to the real scene represented by the virtual stage 108, in order to enable a direct and instantaneous feedback. The further data 122 on the captured real scene and the virtual objects 112, the characters 114, and the rendering based on the virtual camera 116 are supplied to a content creation module 128 which provides the respective data to the application 110 that enables a user to update, adjust, or modify any components of the virtual environment, for example, the virtual objects 112 or the characters 114.

Both, the virtual stage 108 and the application 110 may provide data related to components simulated in the virtual environment, which are supplied to the processing unit 102 or a respective input interface of a pipeline instantiated and controlled by the processing unit 102. In particular, the virtual stage 108 may manage several components related to settings, devices and hardware of the real scene, such as a real camera 132, a time code 134, and a witness camera 136. The components 132, 134, and 136 are used to generate data 138 for the virtual environment, including, but not limited to a live recording, such as a video stream, a time code, and further data. The virtual stage 108 may also manage a virtual representation of the real scene, which may correspond to respective components of the virtual environment and which may be used to generated suitable captured data for respective real objects. The virtual representation may include, for example, props and objects 140, characters 142, virtual cameras 144, and data about respective hardware 146. The virtual representation may be, in particular, used to derive motion data 148 for the respective real object(s) which may be provided to the virtual environment to update the corresponding virtual object(s).

The data 138 and motion data 148 related to the captured real data of the real scene may be combined with corresponding data provided by application 110. For example, a user may use application 110 to access a representation corresponding to the components of the virtual environment, including, for example, props and objects 150, characters 152 and a virtual camera 154. This representation may be directly derived from the content creation module 128 and may therefore directly correspond to the virtual objects 112, characters 114 and virtual camera 116 of the virtual environment. The representation may be accessed by the user of the application 110 and particular components may be modified, adjusted and/or updated. For example, the user may edit meshes and textures related to particular objects 150. Also, the user may adjust or modify properties of characters 152, such as a skeletal representation or a motion path. Also, the user may directly modify parameters of the virtual camera 154. Any modification is provided by the application as a set of data 156 and motion data 158, which are supplied to the virtual environment.

The output of the virtual stage108 and application 110 may, for example, be provided to the motion capture component 104 of the processing unit 102. For example, the data 138 and 156 may be supplied to a data input 160 of the motion capture component 104. Similarly, motion data 148 and 158 may be supplied to a motion retargeter 162 of the motion capture component 104. Component 104 may analyze the input data of the data input 160 and motion retargeter 162 and determine a suitable data update of the virtual objects 112 and other components of the virtual environment as well as of data 122 related to the captured real scene. Hence, any input of real data through virtual stage 108 and updates through application 110 directly influences the state of the virtual environment. Based on the current changes the engine 106 may continue to simulate a next state of the virtual environment.

Even though only one application 110 has been depicted, it is to be understood that multiple applications may be used, each controlled by another user and enabling a collaborative manipulation of components of the virtual environment based on a local representation within the respective application, such as components 150, 152, and 152 of application 110. The output of each application may be combined in the processing unit 102. In particular, any data collisions, conflicts or inconsistencies may be handled by the processing unit 102. For example, if two users attempt to modify the same virtual object 112, they will perform the changes on the respective local representation, such as on the virtual object 150 represented in application 110. The processing unit 102 will recognize the concurrent modifications and may resolve the conflict either by discarding one of the updates, for example, based on priority information related to the user or application, or by merging both data. Also, the processing unit 102 in combination with content creation module 128 may lock particular virtual objects 112, such that only one application 110 may work on the locked virtual object.

Further to application 110, the processing unit 102 may also provide renderings of the virtual environment to one or more computer terminals 160. These computer terminals 160 may allow a user to view and interact with the virtual environment. However, the computer terminals 160 may be configured to provide a limited interaction only, such that the user may not be allowed to update and/or modify the virtual objects 112 and characters 114. Yet, each computer terminal 160 may be associated with a dedicated virtual camera, which may generate a unique view on the virtual environment for the respective computer terminal 160. Furthermore, the user may be allowed to directly control the dedicated virtual camera in order to, for example, enable a walk-through or flight through the virtual environment. Also, the processing unit 102 may provide a storage interface, in order to store any input, output or simulation data to an external storage 162. The data stored may be retrieved from storage 162 and used to re-play the simulation and data input at any time.

While the preferred embodiment has been described in many details, it has to be understood that aspects of the invention can take many forms. In particular, the invention may be practiced within the scope of the claims differently from the examples described and the described features and characteristics may be of importance for the invention in any combination. The embodiments shown herein are intended to illustrate rather than to limit the invention as defined by the claims.

## Claims

1. A method for driving a simulated virtual environment with real data, comprising:
providing a simulated virtual environment including a plurality of virtual objects in a virtual scene;
providing captured data related to one or more real objects of a real scene to the virtual environment;
assigning the captured data to corresponding virtual objects;
updating the plurality of virtual objects in the virtual scene; and
rendering the virtual scene of the simulated virtual environment,
wherein the virtual scene is rendered in real-time with regard to providing the captured data.

2. The method of claim 1, further comprising capturing at least some of the data related to the one or more real objects of the real scene in real-time.

3. The method of claim 2, wherein providing the captured data comprises streaming the captured data live into the virtual environment in real-time.

4. The method of claim 2 or 3, wherein capturing the data comprises recording the real scene using a real camera, further comprising synchronizing a virtual camera inside the virtual scene with the real camera, wherein the virtual scene is rendered using the virtual camera.

5. The method according to one of the claims 2 to 4, wherein capturing the data comprises at least one of capturing motion of a real object, wherein providing the captured data further comprises re-targeting the captured motion data of the real object to a corresponding virtual object; and capturing the data from at least one of an actor, other real objects of the real scene, a real camera, and other devices capturing data of the real scene.

6. The method according to one of the preceding claims, further comprising generating data for at least some of the virtual objects based on the captured data, including at least one of motion data, meshes, and textures for the respective virtual objects, creating a three-dimensional representation of the real scene based on the captured data and compositing at least the three-dimensional representation of the real scene with the rendering of the virtual scene.

7. The method according to one of the preceding claims, further comprising interacting with the virtual environment based on the rendering of the virtual scene, wherein interacting with the virtual environment includes one or more of selecting at least some of the virtual objects and editing the selected virtual objects, controlling a virtual camera using an input device, and interacting with the virtual environment by a plurality of users collaborating in real-time; and preferably further comprising providing the rendering directly at the real scene.

8. A processing pipeline for driving a simulated virtual environment with real data, said processing pipeline being implemented and executed on at least one computing device, comprising:
an input module configured to receive captured data related to one or more real objects of a real scene;
an output module configured to render a virtual scene of a simulated virtual environment; and
one or more interconnected processing modules, at least one of the processing modules being connected to the input module and at least one of the processing modules being connected to the output module, said processing modules being configured to:
provide the simulated virtual environment including a plurality of virtual objects in a virtual scene;
assign the captured data to corresponding virtual objects; and
update the plurality of virtual objects in the virtual scene,
wherein said processing pipeline is configured to render the virtual scene in real-time with regard to providing the captured data.

9. The pipeline of claim 8, wherein the input module is further configured to receive at least some of the captured data related to the one or more real objects of the real scene in real-time, and to stream the captured data live to the processing module providing the virtual environment in real-time.

10. The pipeline of claim 9, further comprising a processing module configured to synchronize a virtual camera inside the virtual scene with a real camera, configured to record the real scene and capture the data, wherein the virtual scene is rendered using the virtual camera.

11. The pipeline of claim 9 or 10, wherein the captured data comprises captured motion data of a real object, and the input module is further configured to re-target the captured motion data of the real object to a corresponding virtual object.

12. A system for driving a simulated virtual environment with real data, comprising:
a processing unit providing a simulated virtual environment including a plurality of virtual objects in a virtual scene, said processing unit including a pipeline according to one of the claims 8 to 11;
an input interface receiving captured data related to one or more real objects of a real scene, configured to provide the captured data to the input module of the pipeline; and
an output interface providing the rendering of the virtual scene of the simulated virtual environment received from the output module of the pipeline, wherein the virtual scene is rendered in real-time with regard to providing the captured data.

13. The system of claim 12, further comprising a capturing device to capture at least some of the data related to the one or more real objects of the real scene in realtime, including a real camera configured to record the real scene, and a motion tracking device configured to capture motion of at least one real object.

14. The system of claim 12 or 13, further comprising a data store coupled to the processing unit to store and retrieve at least some of the captured data, and/or an interaction unit coupled to the processing unit, configured to enable interaction with the virtual environment based on the rendering of the virtual scene provided by the output interface, wherein the interaction unit further comprises an input device to control a virtual camera in the virtual environment.

15. The system according to one of the claims 12 to 14, wherein the processing unit includes a real-time 3D engine configured to simulate the virtual environment.
